# FASCICULE DE BREVET EUROPEEN

(11) **EP 4 474 909 B1**
(45) Date de publication et mention de la délivrance du brevet: **20.05.2026**
(21) Numéro de dépôt: 24178512.0
(22) Date de dépôt: 28.05.2024
(51) Int. Cl.: G03F 7/00, C25D 1/00, C25D 1/10, G04B 13/02, G04B 15/14

(54) **PROCÉDÉ DE FABRICATION D'UN MICRO-MOULE ET DE PIÈCES MICROMÉCANIQUES ET PIÈCES MICROMÉCANIQUES FABRIQUÉES PAR LE PROCÉDÉ**
VERFAHREN ZUR HERSTELLUNG EINES MIKROFORMTEILS UND MIKROMECHANISCHER BAUTEILE, SOWIE NACH DEM VERFAHREN HERGESTELLTE MIKROMECHANISCHE BAUTEILE
METHOD FOR PRODUCING A MICRO-MOULD AND MICRO-MECHANICAL COMPONENTS, AND MICRO-MECHANICAL COMPONENTS PRODUCED BY THE METHOD

(30) Priorité: 01.06.2023 CH 582002023
(43) Date de publication de la demande: 11.12.2024
(73) Titulaire: Mimotec SA, 1950 Sion (CH)
(72) Inventeur: Genolet, Grégoire, 1926 Fully (CH); Konstantinou, Georgia, 1950 Sion (CH); Barberini, Valentin, 1880 Bex (CH)
(74) Mandataire: P&TS SA (AG, Ltd.)

(56) Documents cités:
- EP-A1- 2 672 320
- CH-A2- 715 266
- JP-A- H06 336 690
- ROGNER A ET AL: "THE LIGA TECHNIQUE-WHAT ARE THE NEW OPPORTUNITIES", JOURNAL OF MICROMECHANICS AND MICROENGINEERING, INSTITUTE OF PHYSICS PUBLISHING, BRISTOL, GB, vol. 2, no. 3, 1 September 1992 (1992-09-01), pages 133 - 140, XP001058360, ISSN: 0960-1317, DOI: 10.1088/0960-1317/2/3/004

## Description

### Domaine technique

La présente invention concerne un procédé de fabrication d'un micro-moule apte à la production de pièces mécaniques miniaturisées, ou micropièces, par la technique de micro-fabrication LIGA, ainsi que des pièces miniaturisées ainsi produites. L'invention se prête à un grand nombre d'applications parmi lesquelles on remarque l'horlogerie, la production de MEMS, les composants électriques et/ou optiques de précision, la micro fluidique et beaucoup d'autres.

### Etat de la technique

La technique de micro-fabrication LIGA (Lithographie, Galvanoplastie et Moulage en Allemand) est un processus de fabrication utilisé pour créer des structures microscopiques avec une grande précision et une grande reproductibilité.

Typiquement, le procédé LIGA part d'un substrat plan, par exemple de verre, de métal, de silicium ou en polymère. Sur ce substrat est étalée une couche de résine photosensible, appelée "photorésist" qui est sensible au rayonnement lumineux. On utilise communément des photorésists dits "négatifs" qui polymérisent et deviennent insolubles après avoir été irradiés par de la lumière UV ou bien des rayons X ou des faisceaux d'électrons, mais on connait aussi des photorésists "positifs" qui deviennent solubles après l'exposition.

Une fois le moule obtenu, les cavités ainsi obtenues sont remplies par un métal --- par exemple cuivre, or, nickel, ou un alliage --- grâce à un procédé d'électrodéposition dit électroformage. Ensuite, le métal est démoulé de la résine polymérisée restante et du substrat. On obtient un produit métallique qui reproduit fidèlement, en négatif, les cavités du moule.

Dans le procédé LIGA conventionnel, les cavités ont nécessairement des flancs verticaux, parallèles à la direction d'exposition, et cette limitation se retrouve également dans les produits après le démoulage. Il est également possible d'appliquer le procédé ci-dessus en plusieurs étapes pour obtenir un moule en plusieurs niveaux, chacun construit sur le précédent. Par ces procédés on peut obtenir des structures à marches, mais pas des formes tridimensionnelles arbitraires. Le document EP 3508916 B1 divulgue un procédé de ce type.

On a essayé de contourner cette limitation par des expositions obliques du photorésist, par exemple suivant le procédé divulgué par le document EP 1652009 B1. Cette méthode nécessite une optique plus élaborée, avec un système optique (prismes, réseau de diffraction, diffuseur optique) pour modifier l'angle d'incidence de l'exposition et, dans certains cas, d'un plateau tournant pour le substrat. Malgré ces complications, certaines géométries ne sont pas aisément réalisables.

WO 2023012035 A1 et WO 2023012036 A1 proposent de contourner cette limitation en réalisant des creusures avec des flancs inclinés ou non verticaux dans le substrat de base avant l'étalement du photorésist. Cette technique est limitée à des structures inclinées avec un rapport hauteur/largeur faible et comporte des difficultés spéciales, par exemple le contrôle de la lumière diffusée et réfléchie par le fond de la cavité par des couches antireflets.

Ces deux derniers documents proposent aussi d'utiliser des techniques de stéréolithographie par couches, ou bien une exposition avec un faisceau focalisé à une profondeur voulue à l'intérieur de la couche de photorésist qui polymérise le photorésist par une interaction à deux photons. Si ces techniques peuvent, en principe, créer des structures tridimensionnelles complexes avec des flancs inclinés ou courbés, elles sont considérablement plus lentes que la photolithographie conventionnelle, et nécessitent des photorésists particuliers.

JP H06 336690 A propose un procédé où des creusures sont réalisées par usinage mécanique dans une couche de résine avant une étape d'exposition.

### Bref résumé de l'invention

Dans certains cas, des flancs inclinés sont désirés pour des raisons fonctionnelles ou esthétiques. La présente invention propose un procédé de micro-fabrication analogue aux procédés LIGA connus, avec la possibilité de créer des flancs non-verticaux.

Selon l'invention, ces buts sont atteints notamment au moyen de l'objet des revendications, et notamment par un procédé de fabrication d'un micro-moule comportant les opérations de : étaler une couche de photorésist sur un substrat, ouvrir une ou plusieurs ouvertures dans la couche de photorésist par photolithographie, réaliser un flanc incliné ou des flancs inclinés dans les ouvertures par enlèvement de matière. La réalisation des flancs inclinés peut être obtenue par n'importe quel procédé soustractif, par exemple par micro-usinage laser, par rabotage à l'aide d'une lame diamantée ou bien à l'aide d'un outil de coupe rotatif, par exemple une fraise. En ce dernier cas, le tranchant ou les tranchants de l'outil de coupe sont de préférence en diamant monocristallin, le diamètre nominal de l'outil de coupe est compris entre 0.2 mm et 2 mm et la vitesse de rotation de l'outil de coupe est comprise entre 20'000 révolutions par minute et 100'000 révolutions par minute.

Le procédé de l'invention peut donner lieu à des micro-moules complexes avec des flancs verticaux et inclinés avec une seule opération de photolithographie. Pourtant, l'invention englobe aussi la fabrication de moules avec plusieurs niveaux, étalant une deuxième couche de photorésist comblant les ouvertures et la structurant ensuite par photolithographie. On peut créer des flancs inclinés dans le niveau supérieur comme on l'a illustré pour le premier niveau, et multiplier le nombre de niveaux autant qu'on le souhaite.

L'invention porte aussi sur un procédé de fabrication d'une pièce micromécanique à l'aide d'un micro-moule obtenu comme on l'a expliqué ci-dessus, en remplissant les ouvertures avec un métal électroformé. Après le démoulage, qui est fait avec des procédés classiques, la pièce micromécanique obtenue présente une ou plusieurs faces obliques correspondantes aux flancs inclinés.

On peut aussi, dans l'invention, rectifier une ou les bases de la pièce micromécanique, par exemple par abrasion, par meulage ou les dresser avec un outil pour obtenir une face plane. La rectification de la face supérieure est souvent faite pour corriger les inhomogénéités d'épaisseur du métal au-dessus des ouvertures, appelées communément champignonnage. Dans l'invention on peut aussi rectifier la base inférieure de la pièce micromécanique pour la ramener en contact avec la face oblique. Comme on le verra mieux par la suite, cette étape permet de laisser un espace de garde plus important entre l'outil de coupe et le substrat lors de la création des flancs inclinés.

Les procédés de l'invention permettent de fabriquer des composants horlogers fonctionnels ou décoratifs avec des arêtes anglées et des faces inclinées, par exemple roue dentée, ancre, roue d'échappement, ressort, sautoir, pont, coq, index de cadran, aiguille de montre, et bien d'autre pièces. En sortant du domaine horloger, on peut appliquer l'invention à une variété infinie de pièces micromécaniques ou de MEMS utilisables dans les domaines techniques plus variés. On peut citer comme exemples parmi beaucoup d'autres, les connecteurs pour fibres optiques avec entailles en "V" et les pointes de contact pour le test de circuits électroniques.

L'invention permet de réaliser des pièces micromécaniques avec des faces non verticales de manière simple et précise sans renoncer aux avantages propres au procédé LIGA, notamment la grande précision et l'économicité.

Dans ce document on utilisera la formulation "vertical" en rapport à l'orientation conventionnelle des procédés LIGA : la direction "verticale" indique en ce contexte une direction orthogonale au substrat, qui est conventionnellement considéré comme horizontal. On pourrait aussi, de manière équivalente, définir la verticale comme la direction du faisceau de radiation utilisé dans les opérations de photolithographie. On utilisera les expressions "oblique", "anglé" et "incliné" pour désigner des éléments géométriques - faces, arêtes ou flancs - qui ne sont pas verticaux ou horizontaux. On utilisera également indifféremment les expressions microcomposant, composant, pièce, pièce mécanique miniaturisée, ou micropièce, pour désigner une pièce micromécanique.

### Brève description des figures

Des exemples de mise en œuvre de l'invention sont indiqués dans la description illustrée par les figures annexées qui illustrent l'invention de manière schématique et idéalisée.
Les figures de 1a à 1h représentent huit étapes d'un procédé de fabrication d'un micro-moule et d'une pièce micromécanique.
Les figures de 2a à 2j montrent un procédé alternatif de l'invention.
Les figures 3a à 3g montrent une autre variante du procédé inventif.
Les figures 4a à 4i illustrent une autre variante du procédé.
La figure 5 illustre une roue d'horlogerie avec des arêtes anglées selon l'invention.
La figure 6 montre une pointe de contact pour circuits microélectroniques de type conventionnel faite par procédé UV-LIGA.
La figure 7 montre une pointe de contact selon l'invention avec des performances mécaniques supérieures.

Les éléments remarquables des figures sont identifiés par des signes de référence qui sont repris dans le texte. Le même signe peut être utilisé pour désigner plusieurs éléments identiques ou équivalents. Lorsqu'une figure comporte une pluralité d'éléments identiques ou équivalents, certains signes de référence ont pu être omis pour ne pas surcharger les dessins.

### Exemple(s) de mode de réalisation de l'invention

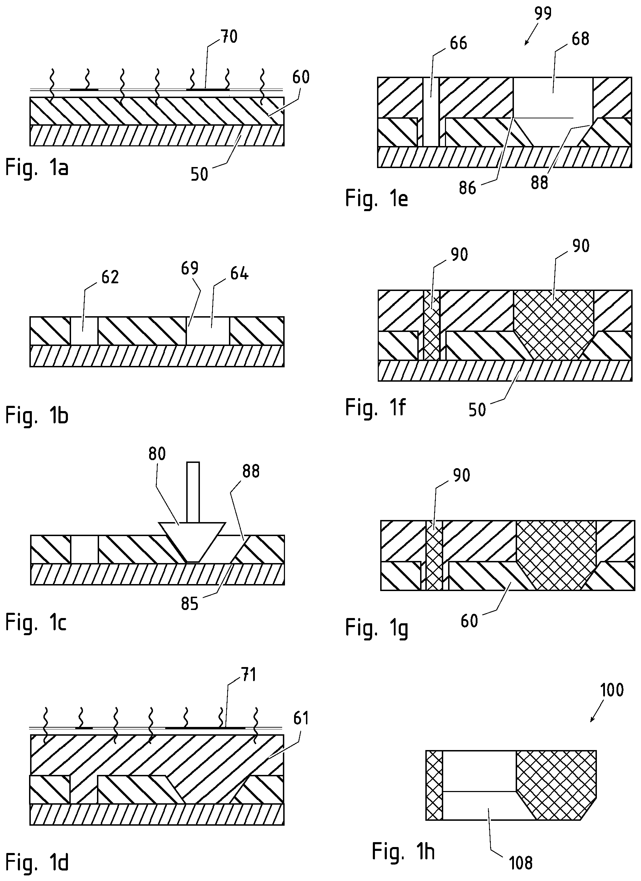

Les figures 1a-1h illustrent un procédé de fabrication de micro-moules et de microcomposants anglés selon un premier mode de réalisation. La figure détaille uniquement la fabrication d'un micro-moule et du microcomposant correspondant, mais il va de soi qu'avec ce procédé on peut fabriquer en parallèle une pluralité de micro-moules et de microcomposants sur un substrat. Le procédé sera ici décrit en détaillant seulement les étapes principales nécessaires à comprendre les solutions techniques utilisées par l'invention. Un lecteur informé saura que le procédé LIGA comprend aussi d'autres étapes (préparation des surfaces, lavage, déposition de couches conductrices, dépose du photorésist, séchage, alignement, exposition, développement, ...) que l'on n'a pas indiqué dans un souci de concision.

La figure 1a montre une coupe d'un substrat 50 sur lequel une première couche de photorésist 60 a été étalée. Le substrat pourrait être en métal, en verre, en silicium, en polymère, ou bien tout autre matériau approprié. Il est avantageux, dans le cas des substrats non-conducteurs, d'interposer une couche conductrice (non représentée) entre le substrat 50 et le photorésist 60.

Des essais convaincants ont été conduits avec un photorésist négatif de type SU-8, mais d'autres choix sont possibles. L'épaisseur de la première couche de photorésist 60 correspond à la hauteur de la face inclinée que l'on souhaite obtenir. Dans les pièces horlogères, il est usuel d'angler les arêtes à des hauteurs comprises entre 30 µm et 300 µm, mais des dimensions plus petites ou plus importantes sont à la portée de cette technique.

Un photomasque 70 aligné au-dessus de la face supérieure de la couche de photorésist 60 permet d'irradier sélectivement cette dernière et d'obtenir la polymérisation des parties que l'on souhaite préserver. La figure 1b montre l'ensemble après l'exposition et le développement du photorésist. Les parties protégées par le photomasque se dissolvent dans le développement et laissent des ouvertures 62, 64. Les flancs 69 des ouvertures suivent l'axe du faisceau utilisé pour l'irradiation et sont donc verticaux.

La figure 1c montre une étape dans laquelle les ouvertures de la couche de photorésist sont usinées pour réaliser des flancs inclinés 88 aux endroits requis. L'usinage est réalisé ici par une fraise conique 80, mais d'autres techniques de fabrication soustractive seraient possibles.

Les inventeurs ont obtenu des résultats très favorables, en termes de précision et qualité des surfaces en utilisant des fraises en diamant monocristallin avec un diamètre nominal de 0.2 mm à 2 mm et des vitesses de rotation entre 20'000 révolutions par minute et 100'000 révolutions par minute. Les fraises sont montées sur une machine de micro-fraisage à contrôle numérique.

Un point délicat de cette technique est que certaines formes requièrent un fraisage effleurant le substrat (voir point de transition 85). Il est préférable alors d'utiliser un substrat métallique ou en polymère pouvant être facilement usiné.

La figure 1d montre une deuxième couche de photorésist 61 étalée sur la première. Cette deuxième couche comble toutes les ouvertures réalisées dans la première couche et son épaisseur correspond sensiblement à la hauteur totale du composant à réaliser. La deuxième couche est exposée à travers un photomasque 71 et développée pour donner le micro-moule 99 visible sur la figure 1e. Dans le micro-moule 99 des ouvertures 66 avec des flancs droits et des ouvertures 68 avec des flancs au moins partiellement inclinés peuvent être réalisées. Le raccord entre les flancs verticaux structurés dans la deuxième couche de photorésist 61 et les flancs inclinés 88 peut se faire à l'aplomb du bord des ouvertures sur la première couche (point 86) ou sur le flanc incliné (point 88).

Les cavités du micro-moule 99 sont remplies de métal par une étape d'électroformage (figure 1f). Le substrat est retiré (figure 1g) et le composant 100 est ensuite démoulé (figure 1h). Ces deux dernières étapes peuvent être interverties.

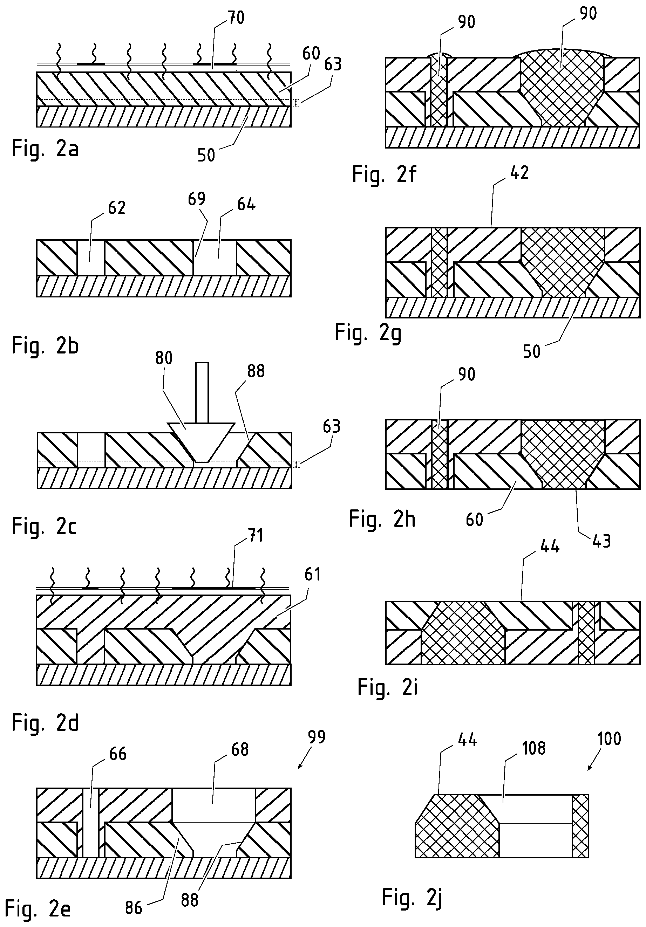

Un point délicat du procédé exemplifié ci-dessus est le fraisage à fleur du substrat (figure 1c, point d'intersection 85). Afin de pouvoir utiliser des substrats fragiles comme le silicium et le verre, on peut introduire une surépaisseur de photorésist comme le montrent les figures 2a à 2j qui illustrent un deuxième mode de réalisation. La hauteur de la première couche de photorésist 60 est ainsi égale à la hauteur de l'anglage que l'on souhaite réaliser, plus une distance de sécurité donnée, par exemple entre 10 µm et 30 µm. Cette surépaisseur peut être considéré comme une couche de sécurité pour le substrat 50. La couche de sécurité 63 est indiquée graphiquement sur les figures 2a et 2c. On comprend que cette séparation est une notion purement géométrique et qu'en effet la couche de sécurité 63 fait partie intégrante de la première couche de photorésist 60 sans discontinuité.

Après l'étalement, l'exposition et le développement de la première couche de photorésist (figures 2a et 2b) qui se déroulent comme dans l'exemple précédent, L'usinage de la première couche de photorésist 60 n'est pas fait sur toute la hauteur de la première couche. La fraise épargne le photorésist dans la couche de sécurité 63 (voir figure 2c). Grâce à cette distance supplémentaire de sécurité entre l'outil 80 et le substrat 50 on peut employer des substrats cassants sans danger pour ce dernier ou pour l'outil.

Le procédé se déroule, comme dans l'exemple précédant, par l'étalement d'une nouvelle couche de photorésist 61 et son exposition à travers un deuxième photomasque 71 (figure 2d), la fabrication du micro-moule 99 avec le développement de la deuxième couche 61 (figure 2e), le remplissage du micro-moule par du métal 90 (figure 2f). La figure 2f montre le champignonnage du métal au-dessus de la face supérieure du micro-moule, qui est en quelque sorte inhérent au procédé. Les faces supérieures du micro-moule et du dépôt métallique 90 sont usinées afin d'obtenir une surface usinée 42 unique plane sans aucun débordement (figure 2g). Cette rectification est réalisable par abrasion, par meulage ou par un dressage à plat avec une fraise, ou par n'importe quel procédé de mise en œuvre approprié.

Après le retrait du substrat 50 (figure 2h) on obtient un ensemble avec une hauteur égale à la hauteur du composant souhaité, plus celle de la couche de sécurité 63. Cette surépaisseur est alors éliminée avec une deuxième opération de rectification sur la face 43 qui reposait contre le substrat pour supprimer la surépaisseur de métal crée par la couche de sécurité 63. On obtient (figure 2i) un ensemble avec une épaisseur égale à celle du composant et une surface 44 plane correspondante à celle du composant. Le démoulage donne finalement (figure 2j) le composant souhaité 100 avec des surfaces inclinées 108 qui se joignent à la surface 44 par une arête franche, sans marche.

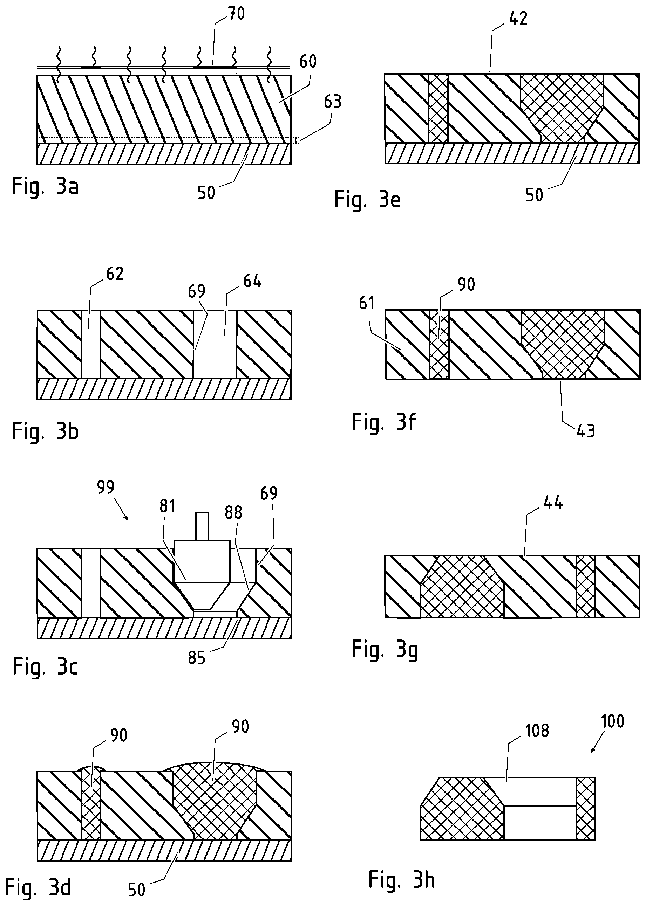

Dans un troisième mode de réalisation on peut aussi utiliser l'invention avec des procédés LIGA à un seul niveau de photorésist, comme le montre l'exemple illustré sur les figures 3a à 3h. Dans cet exemple, la couche de photorésist 60 est étalée avec une épaisseur sensiblement égale à la hauteur du microcomposant à réaliser, réhaussée par la couche de sécurité 63. Les étapes d'étalement, d'exposition (figure 3a) et de développement (figure 3b) se déroulent comme dans les exemples précédents.

A l'aide d'un outil à forme spéciale 81 (voir figure 3c) certaines ouvertures sont agrandies (flanc vertical élargi 69) et anglées dans une seule opération d'usinage L'outil permet de réaliser en même temps les flancs inclinés 88 qui donneront lieu aux faces anglés de la pièce micromécanique 100 souhaitée, et les flancs verticaux 69 du moule qui correspondent à des faces verticales de la pièce 100, visibles sur la figure 3h. Les figures 3d à 3g montrent les étapes intermédiaires du remplissage du micro-moule 99, de l'usinage des faces supérieures du micro-moule et du dépôt métallique 90 afin d'obtenir la surface usinée 42, du retrait du substrat 50, de la rectification de la face 43 afin d'obtenir la surface 44, et du démoulage du composant 100 (figure 3h) qui se déroulent comme dans les exemples précédents.

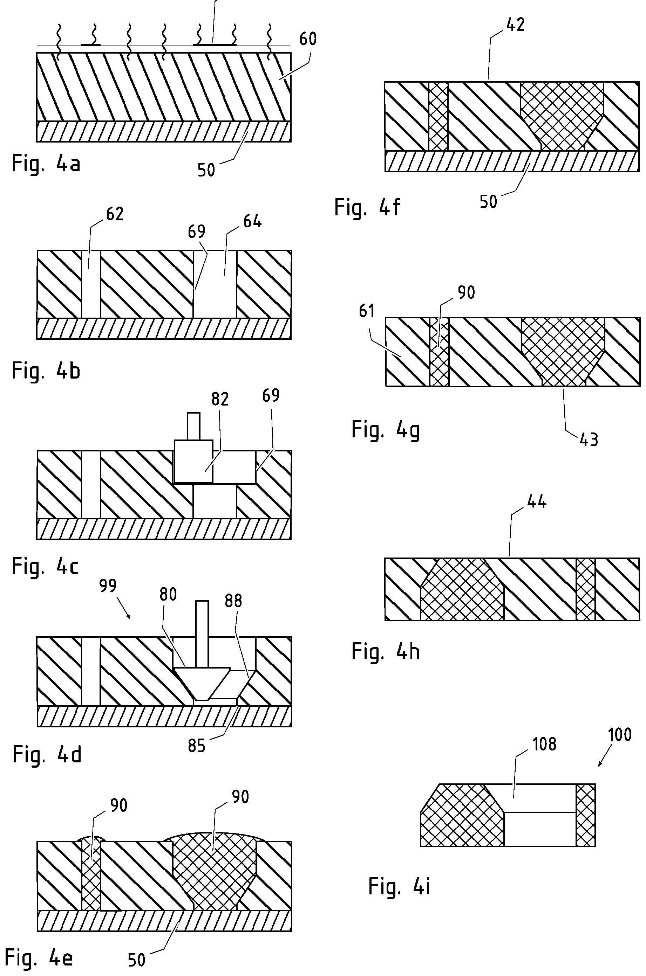

Les figures 4a à 4i montrent un quatrième mode de réalisation. Les étapes d'étalement et d'exposition de la première couche de photorésist 60 (figure 4a) et de développement (figure 4b) correspondent à celles de l'exemple précédent. L'usinage des flancs de l'ouverture 64 de cette couche de photorésist 60 est faite en deux temps . Le flanc vertical 69 est d'abord créé par une opération de lamage avec une fraise droite 82 (figure 4c). Dans ce but, une fraise à une dent en diamant monocristallin peut être utilisée. Le flanc incliné sous-jacent est créé ensuite par une deuxième opération de fraisage à l'aide d'une fraise conique 80 (figure 4d).

Une fois le micro-moule 99 fabriqué, le procédé continue comme dans l'exemple précédant avec les étapes de remplissage (Figure 4e), d'usinage des faces supérieures du micro-moule et du dépôt métallique 90 afin d'obtenir la surface usinée 42 (figure 4f), du retrait du substrat 50 (figure 4g), de la rectification de la face 43 afin d'obtenir la surface 44 (figure 4h), du démoulage du composant 100 (figure 4i).

On notera que, de manière préférée, les étapes du procédé selon les différents modes de réalisations suivent l'ordre tel qu'illustré dans les figures 1a à 1h, 2a à 2j, 3a à 3g, et 4a à 4i, respectivement. Cependant, on admettra qu'un ordre différent des étapes peut être envisagé. Par exemple, dans le premier mode de réalisation, les étapes du procédé de 1a à 1f sont exécutées selon l'ordre illustré et un ordre différent peut être envisagé pour les étapes de 1g à 1h. Dans le deuxième mode de réalisation, les étapes du procédé de 2a à 2f sont exécutées selon l'ordre illustré et un ordre différent peut être envisagé pour les étapes de 2g à 2j. Dans le troisième mode de réalisation, les étapes du procédé de 3a à 3d sont exécutées selon l'ordre illustré et un ordre différent peut être envisagé pour les étapes de 3e à 3h. Dans le quatrième mode de réalisation, les étapes du procédé de 4a à 4e sont exécutées selon l'ordre illustré et un ordre différent peut être envisagé pour les étapes de 4f à 4i.

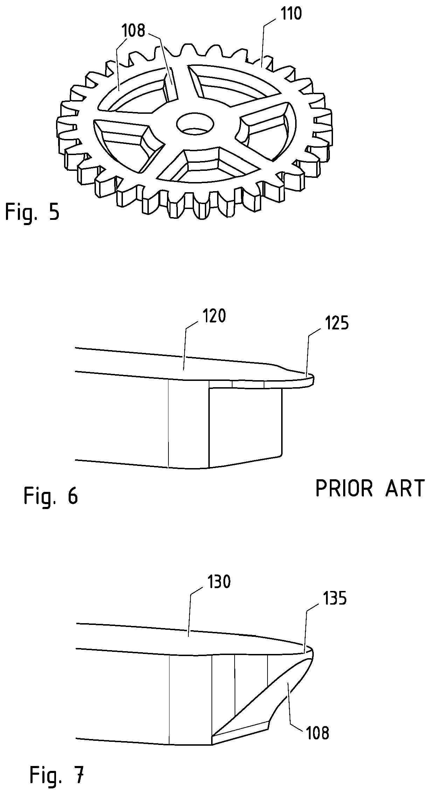

La figure 5 montre un exemple de microcomposant horloger selon l'invention. Il s'agit en ce cas d'une roue dentée avec ses bras anglés. L'invention permet la fabrication de composants horlogers anglés ou avec des faces inclinées ou biseautées de toute sorte. Quelques exemples non-exhaustifs :
- Ancres d'échappement avec un corps anglé
- Ressorts et sautoirs
- Roues d'ancre anglées avec optionnellement des dents à bout biseauté
- Ponts, coq
- Eléments d'habillage ou décoratifs tels que index de cadran, logos, aiguilles.

La figure 6 montre l'extrémité 125 d'une pointe 120 destinée à tester des composants électroniques, fortement agrandie. Ces pièces sont aussi communément appelées *"MEMS probes"* dans le domaine des tests électroniques. Il est important d'avoir une surface de la pointe le plus faible possible afin d'obtenir un contact optimal entre la pointe et le contact de la puce électronique. Dans l'exemple ci-dessus on définit une hauteur de contact d'environ 10 microns, qui pourrait créer un flambage de la pointe lors de sa fonction.

La figure 7 montre l'extrémité 135 d'une pointe de test 130 de l'invention. On remarque qu'il est désormais possible de réaliser une pointe avec une surface de contact très faible unie au corps de la pointe par une surface inclinée 108, A surface de contact égale, cette pointe est beaucoup plus résistante au flambage que la pointe 120 réalisée par procédé UV-LIGA traditionnel.

Le procédé de fabrication décrit ici permet de produire une pièce micromécanique 100 dans laquelle l'intersection entre les surfaces inclinées 108 forme une arête franche avec un angle précis. Une telle précision ne peut être obtenue en usinant directement la pièce micromécanique. Dans ce cas, l'intersection entre les surfaces inclinées formerait plutôt un angle arrondi.

Un autre avantage de l'invention est la simplification de fabrication du micro-moule pour les composants de type MEMS probe. Dans le cas de la figure 6 le micro-moule de la pointe doit être rendu conducteur afin de permettre l'électrodéposition de la pointe 125. Il s'agit donc d'opérations additionnelles décrites notamment dans le document EP 3508916 B1. Avec cette invention le flanc incliné du micro-moule va se remplir de manière naturelle lors de l'électrodéposition sans devoir rendre conducteur les flancs inclinés.

### Numéros de référence employés sur les figures

- 42: surface usinée- dessus du moule
- 43: surface destinée à être rectifiée
- 44: surface - dessous du moule
- 50: substrat
- 60: photorésist -- 1^{e} couche
- 61: photorésist -- 2^{e} couche
- 62: ouverture
- 63: couche de sécurité
- 64: ouverture
- 66: ouverture
- 68: ouverture
- 69: flanc vertical
- 70: photomasque
- 71: photomasque - 2^{e} exposition
- 80: outil de coupe, fraise conique
- 81: outil de coupe, fraise de forme
- 82: outil de coupe, fraise droite
- 85: transition
- 86: transition
- 88: flanc incliné
- 90: dépôt métallique électroformé
- 99: micro-moule
- 100: pièce micromécanique, MEMS
- 110: roue d'horlogerie
- 108: surface inclinée de la pièce mécanique miniaturisée
- 120: pointe de contact
- 125: sommet de la pointe
- 130: pointe de contact selon l'invention
- 135: sommet de la pointe

## Revendications

1. Procédé de fabrication d'un micro-moule (99) comportant les opérations de :
Etaler une couche de photorésist (60) sur un substrat (50),
ouvrir par photolithographie une ou plusieurs ouvertures (64, 62) avec un flanc vertical dans la couche de photorésist par photolithographie,
dans au moins une ouverture (64), réaliser un usinage par enlèvement de matière du flanc vertical de manière à créer au moins un flanc incliné (88) sur au moins une portion de la hauteur de la couche de photorésist (60).

2. Procédé selon la revendication 1,
dans lequel l'usinage est réalisé à l'aide d'un outil de coupe, par exemple une fraise (80, 81).

3. Procédé selon la revendication 2,
dans lequel le tranchant ou les tranchants de l'outil de coupe (80, 81, 82) sont en diamant monocristallin.

4. Procédé selon l'une des revendications de 1 à 3,
dans lequel ledit au moins au moins un flanc incliné (88) est réalisé sur toute la hauteur de la couche de photorésist (60).

5. Procédé selon l'une des revendications de 1 à 3,
dans lequel ledit au moins au moins un flanc incliné (88) est réalisé jusqu'à une distance du substrat (50) de manière à former une couche de sécurité (63) entre ledit au moins au moins un flanc incliné (88) de l'ouverture (64) et le substrat (50).

6. Procédé selon l'une des revendications de 1 à 3,
dans lequel l'usinage comprend créer un flanc vertical élargi (69) de sorte à agrandir la dimension latérale de l'ouverture (64), sur une portion de la hauteur de la couche de photorésist (60); et
créer ledit au moins un flanc incliné (88) sur une autre portion de la hauteur de la couche de photorésist (60).

7. Procédé selon la revendication 6,
dans lequel le flanc vertical élargi (69) est réalisé par une première opération de fraisage avec une fraise droite (82); et
dans lequel le flanc incliné (88) est créé ensuite par une deuxième opération de fraisage à l'aide d'une fraise conique (8).

8. Procédé selon la revendication 6,
dans lequel le flanc vertical élargi (69) et le flanc incliné (88) sont créés par une seule opération de fraisage avec une seule fraise (81) comportant une portion droite et une portion conique.

9. Procédé selon l'une des revendications de 1 à 4,
comportant, après la réalisation des flancs inclinés (88), l'étalement d'une deuxième couche de photorésist (61) comblant les ouvertures (62, 62) et la structuration de la deuxième couche de photorésist par photolithographie.

10. Procédé de fabrication d'une pièce micromécanique (100) comportant la fabrication d'un micro-moule (99) selon l'une des revendications 1 à 9,
suivie par le remplissage des ouvertures par un métal (90) dans une étape d'électroformage et par le démoulage de la pièce micromécanique (100) ainsi formée, la pièce micromécanique obtenue présentant une ou plusieurs faces inclinées (108) correspondantes aux flancs inclinés (88).

11. Procédé selon la revendication 10 et la revendication 5, comprenant une étape de rectification pour éliminer la couche de sécurité (63) et ramener ainsi une surface (44) de la pièce micromécanique (100) en contact avec le ou la face inclinée (108).

12. Pièce micromécanique (100) réalisée selon le procédé selon la revendication 10 ou 11,
constituant un composant horloger fonctionnel ou décoratif avec des arêtes anglées, par exemple roue dentée (110), ancre, roue d'échappement, ressort, sautoir, pont, coq, index de cadran ou aiguille de montre; ou
constituant un composant tel que : connecteur pour fibres optiques, pointe de contact pour le test de circuits électroniques (130).

## Patentansprüche

1. Verfahren zur Herstellung einer Mikrofigur (99), umfassend die folgenden Schritte:
Aufbringen einer Photoresistschicht (60) auf ein Substrat (50),
photolithographisches Öffnen einer oder mehrerer Öffnungen (64, 62) mit einer vertikalen Flanke in der Photoresistschicht durch Photolithographie,
in mindestens einer Öffnung (64) eine spanende Bearbeitung der senkrechten Flanke durchführen, um mindestens eine geneigte Flanke (88) auf mindestens einem Abschnitt der Höhe der Photoresistschicht (60) zu erzeugen.

2. Das Verfahren nach Anspruch 1,
wobei die Bearbeitung mit einem Schneidwerkzeug, beispielsweise einem Fräser (80, 81), durchgeführt wird.

3. Das Verfahren nach Anspruch 2,
wobei die Schneide oder die Schneiden des Schneidwerkzeugs (80, 81, 82) aus einkristallinem Diamant bestehen.

4. Das Verfahren nach einem der Ansprüche 1 bis 3,
wobei die mindestens eine geneigte Flanke (88) über die gesamte Höhe der Photoresistschicht (60) ausgebildet ist.

5. Das Verfahren nach einem der Ansprüche 1 bis 3,
wobei die mindestens eine geneigte Flanke (88) bis zu einem Abstand vom Substrat (50) ausgebildet ist, um eine Sicherheitsschicht (63) zwischen der mindestens einen geneigten Flanke (88) der Öffnung (64) und dem Substrat (50) zu bilden.

6. Das Verfahren nach einem der Ansprüche 1 bis 3,
wobei die Bearbeitung Folgendes umfasst: Erzeugen einer verbreiterten vertikalen Flanke (69), um die seitliche Abmessung der Öffnung (64) zu vergrößern, über einen Teil der Höhe der Photoresistschicht (60); und Erzeugen der mindestens einen geneigten Flanke (88) über einen weiteren Abschnitt der Höhe der Photoresistschicht (60).

7. Das Verfahren nach Anspruch 6,
wobei die verbreiterte vertikale Flanke (69) durch einen ersten Fräsvorgang mit einem geraden Fräser (82) hergestellt wird; und
wobei die geneigte Flanke (88) anschließend durch einen zweiten Fräsvorgang mit einem konischen Fräser (8) erzeugt wird.

8. Das Verfahren nach Anspruch 6,
wobei die verbreiterte vertikale Flanke (69) und die geneigte Flanke (88) durch einen einzigen Fräsvorgang mit einem einzigen Fräser (81) mit einem geraden Abschnitt und einem konischen Abschnitt erzeugt werden.

9. Das Verfahren nach einem der Ansprüche 1 bis 4,
das nach der Herstellung der geneigten Flanken (88) das Aufbringen einer zweiten Photoresistschicht (61), die die Öffnungen (62, 62) ausfüllt, und die Strukturierung der zweiten Photoresistschicht durch Photolithografie umfasst.

10. Das Verfahren zur Herstellung eines mikromechanischen Bauteils (100), umfassend die Herstellung einer Mikrofigur (99) gemäß einem der Ansprüche 1 bis 9,
gefolgt vom Füllen der Öffnungen mit einem Metall (90) in einem Galvanoplastikschritt, und vom Entformen des so hergestellten mikromechanischen Bauteils (100), wobei das erhaltene mikromechanische Bauteil eine oder mehrere geneigte Flächen (108) aufweist, die den geneigten Flanken (88) entsprechen.

11. Das Verfahren nach Anspruch 10 und Anspruch 5,
einen Schleifschritt zum Entfernen der Sicherheitsschicht (63) und damit zum Herstellen eines Kontakts zwischen einer Oberfläche (44) des mikromechanischen Bauteils (100) und der geneigten Fläche (108) umfasst.

12. Mikromechanisches Bauteil (100), hergestellt nach dem Verfahren gemäß Anspruch 10 oder 11,
das eine funktionelle oder dekorative Uhrenkomponente mit abgeschrägten Kanten bildet, beispielsweise ein Zahnrad (110), eine Ankerhemmung, ein Hemmungsrad, eine Feder, eine Sprungfeder, eine Brücke, eine Unruh, ein Zifferblattindex oder ein Zeiger einer Uhr; oder das ein Bauteil wie beispielsweise einen Stecker für optische Fasern, oder eine Kontaktnadel zum Testen elektronischer Schaltungen (130) bildet.

## Claims

1. A process for manufacturing a micro-mold (99), comprising the steps of:
spreading a layer of photoresist (60) on a substrate (50),
forming, by photolithography, one or more openings (64, 62) with a vertical sidewall in the layer of photoresist,
in at least one opening (64), carrying out a machining operation by material removal of the vertical sidewall so as to create at least one inclined sidewall (88) over at least a portion of the height of the photoresist layer (60).

2. The process according to claim 1,
wherein the machining is performed using a cutting tool, for example a milling cutter (80, 81).

3. The process according to claim 2,
wherein the cutting edge or edges of the cutting tool (80, 81, 82) are made of single-crystal diamond.

4. The process according to any one of claims 1 to 3,
wherein said at least one inclined sidewall (88) is formed over the entire height of the photoresist layer (60).

5. The process according to any one of claims 1 to 3,
wherein said at least one inclined sidewall (88) is formed up to a distance from the substrate (50) so as to form a safety layer (63) between said at least one inclined sidewall (88) of the opening (64) and the substrate (50).

6. The process according to any one of claims 1 to 3,
wherein the machining comprises: creating a widened vertical sidewall (69) so as to increase the lateral dimension of the opening (64), over a portion of the height of the photoresist layer (60); and
creating said at least one inclined sidewall (88) over another portion of the height of the photoresist layer (60).

7. The process according to claim 6,
wherein the widened vertical sidewall (69) is produced by a first milling operation using a straight milling cutter (82); and
wherein the inclined sidewall (88) is subsequently created by a second milling operation using a tapered milling cutter (80).

8. The process according to claim 6,
wherein the widened vertical sidewall (69) and the inclined sidewall (88) are created in a single milling operation using a single milling cutter (81) comprising a straight portion and a tapered portion.

9. The process according to any one of claims 1 to 4,
further comprising, after forming the inclined sidewalls (88), the step of spreading a second layer of photoresist (61) filling the openings (64, 62), and structuring the second layer of photoresist by photolithography.

10. A process for manufacturing a micromechanical part (100), comprising the manufacture of a micro-mold (99) according to any one of claims 1 to 9,
followed by filling the openings with a metal (90) in an electroforming step, and by demolding the micromechanical part (100) thus formed, the obtained micromechanical part comprising one or more inclined faces (108) corresponding to the inclined sidewalls (88).

11. The process according to claim 10 and claim 5,
comprising a grinding step to remove the safety layer (63) and thereby bring a surface (44) of the micromechanical part (100) into contact with the inclined face (108).

12. A micromechanical part (100) produced according to the process of claim 10 or 11,
constituting a functional or decorative watchmaking component with angled edges, for example a toothed wheel (110), pallet, escape wheel, spring, jumper spring, bridge, cock, dial index or watch hand; or constituting a component such as: an optical fiber connector, or a contact probe for testing electronic circuits (130).
